# EUROPÄISCHE PATENTANMELDUNG

(11) **EP 1 148 512 A2**
(43) Veröffentlichungstag der Anmeldung: **24.10.2001**
(21) Anmeldenummer: 01105035.8
(22) Anmeldetag: 01.03.2001
(51) Int. Cl.: G11C 11/22

(54) **Verfahren zum Betrieb eines integrierten Speichers**

(30) Priorität: 07.04.2000 DE 10017368
(71) Anmelder: Infineon Technologies AG, 81669 München (DE)
(72) Erfinder: Esterl, Robert, 81287 München (DE); Hönigschmid, Heinz, East Fishkill, NY 12524 (US); Kandolf, Helmut, 81669 München (DE); Röhr, Thomas, Dr., 85609 Aschheim (DE)
(74) Vertreter: Epping Hermann & Fischer

(57) **Zusammenfassung**

Es wird ein Verfahren zum Betrieb eines integrierten Speichers beschrieben, der Speicherzellen (MC0; MC255) mit jeweils einem Auswahltransistor (T0, T255) und einem Speicherkondensator (C0, C255) mit ferroelektrischem Speichereffekt aufweist. Der Speicher enthält eine Plattenleitung (PL), die über eine Reihenschaltung des Auswahltransistors (T0) und des Speicherkondensators (C0) jeweiliger Speicherzellen (MC0) mit einer der Spaltenleitungen (BLt) verbunden ist. Ein Speicherzugriff wird nach dem sogenannten "Pulsed Plate Concept" durchgeführt. Der zeitliche Ablauf wird dabei so gesteuert, daß in einem Zugriffszyklus der Speicherkondensator (C0) der auszuwählenden Speicherzelle (MC0) jeweils um den gleichen Betrag aufgeladen und entladen wird. So wird eine durch Source-Drain-Leckströme von nicht aktivierten Auswahltransistoren verursachte Abschwächung oder Zerstörung der in den Speicherzellen gespeicherten Information vermieden.

## Beschreibung

Die vorliegende Erfindung betrifft ein Verfahren zum Betrieb eines integrierten Speichers mit einem Speicherzellenfeld, das Spaltenleitungen und Zeilenleitungen aufweist, mit Speicherzellen, die jeweils einen Auswahltransistor und einen Speicherkondensator mit ferroelektrischem Speichereffekt aufweisen, und mit einer Plattenleitung, die über eine Reihenschaltung des Auswahltransistors und des Speicherkondensators jeweiliger Speicherzellen mit einer der Spaltenleitungen verbunden ist, und bei dem Steueranschlüsse der Auswahltransistoren der Speicherzellen mit jeweils einer der Zeilenleitungen verbunden ist.

Integrierte Speicher mit sogenannten FeRAM-Speicherzellen, die einen ferroelektrischen Speichereffekt aufweisen, sind oftmals ähnlich aufgebaut wie beispielsweise DRAM Speicher. Dort sind die Speicherzellen üblicherweise in einem matrix-förmigen Speicherzellenfeld zu Einheiten von Spaltenleitungen und Zeilenleitungen zusammengefaßt. Die Speicherzellen umfassen jeweils einen Auswahltransistor und einen Speicherkondensator. Dabei sind die Steueranschlüsse der jeweiligen Auswahltransistoren der Speicherzellen mit jeweils einer der Zeilenleitungen verbunden. Die Spaltenleitungen sind im allgemeinen an einen Leseverstärker angeschlossen, an dem ein bewertetes und verstärktes Datensignal abgreifbar ist.

In Speicherzellen mit ferroelektrischem Speichereffekt werden Datensignale bekanntlich in Form von unterscheidbaren Polarisationszuständen des Materials in einem Speicherkondensator der Speicherzelle gespeichert. Im Betrieb des Speichers weisen die Speicherzellen im allgemeinen ein kapazitives Verhaltes auf. Integrierte Speicher mit derartigen Speicherzellen sind beispielsweise als sogenannte FeRAMs bekannt. Die Speicherzellen bzw. deren Reihenschaltung aus Auswahltransistor und Speicherkondensator sind dabei üblicherweise zwischen eine der Spaltenleitungen und eine Plattenleitung, auch als sogenannte "Plate" bezeichnet, geschaltet. Diese Plattenleitung ist meist mit einer Treiberschaltung verbunden, durch die die Plattenleitung an einem vorgegebenen Potential anliegt.

Im Betrieb des integrierten Speichers weisen die Spaltenleitungen und die Plattenleitungen des Speichers jeweils aktive oder inaktive Betriebsarten auf. In einer aktiven Betriebsart, in der beispielsweise der Inhalt einer der Speicherzellen ausgelesen wird, ist der entsprechende Auswahltransistor aktiviert und die entsprechende Spaltenleitung mit einem Leseverstärker verbunden. Die Plattenleitung liegt an einem vorgegebenen Potential an. Es liegt daher zwischen der Plattenleitung und der entsprechenden Spaltenleitung eine Differenzspannung an. In einer inaktiven Betriebsart sind die entsprechenden Spaltenleitungen und die Plattenleitungen im allgemeinen mit einem Anschluß für ein gemeinsames Versorgungspotential verbunden.

Über die jeweiligen Source-Drain-Strecken von nicht aktivierten Auswahltransistoren nicht ausgewählter Speicherzellen liegt nun während eines Zugriffszyklus ebenfalls eine Differenzspannung zwischen der jeweiligen Spaltenleitung und Plattenleitung an. Diese Source-Drain-Spannung kann einen sogenannten Leckstrom in dem jeweiligen Auswahltransistor verursachen. Bei jedem Zugriffszyklus werden dabei die zugehörigen Speicherkondensatoren von nicht ausgewählten Speicherzellen um gewisse Ladungsmengen aufgeladen und/oder entladen. Dadurch kann sich bei jedem Zugriffszyklus die Spannung an dem jeweiligen Speicherkondensator ändern.

Bei einem ferroelektrischen Speicher wird die Information in einer Speicherzelle durch den Betrag der remanenten Polarisation gespeichert, wobei zwischen den Anschlüssen des Speicherkondensators keine Spannung anliegt. Das Auslesen der Information wird durch kurzzeitiges Anlegen einer Spannung an den Anschlüssen des Kondensators erreicht. Durch die beschriebene Auf- oder Entladung des Speicherkondensators in Folge eines Leckstroms und durch die damit verbundene Potentialänderung über dem Kondensator kann mit der Zeit bzw. nach mehreren Zugriffszyklen die in der Speicherzelle gespeicherte Information geschwächt oder zerstört werden.

Die Aufgabe der vorliegenden Erfindung ist es, ein Verfahren zum Betrieb eines integrierten Speichers der eingangs genannten Art anzugeben, bei dem eine durch Source-Drain-Leckströme von Auswahltransistoren verursachte Abschwächung oder Zerstörung der in einer Speicherzelle gespeicherten Information vermieden wird.

Die Aufgabe wird gelöst durch ein Verfahren zum Betrieb eines integrierten Speichers der eingangs genannten Art, bei dem ein Zugriff auf eine der Speicherzellen in einem Zugriffszyklus erfolgt, wobei das Verfahren folgende Merkmale aufweist:
- vor einem Zugriff weisen die Spaltenleitung und die Plattenleitung, die an einer auszuwählenden Speicherzelle angeschlossen sind, ein Ausgangspotential auf,
- während eines Zugriffs wird die Zeilenleitung aktiviert, die an der auszuwählenden Speicherzelle angeschlossen ist, so daß deren Auswahltransistor leitend geschaltet ist, und es wird an die Plattenleitung ein Potential angelegt, das unterschiedlich zum Potential der Spaltenleitung ist,
- das an der Spaltenleitung anliegende Potential wird zu einem ersten Zeitpunkt bewertet und verstärkt,
- danach wird das Ausgangspotential zu einem zweiten Zeitpunkt an die Plattenleitung angelegt,
- danach wird das Ausgangspotential zu einem dritten Zeitpunkt an die Spaltenleitung angelegt,
- es sind dabei der erste Zeitpunkt, der zweite Zeitpunkt und der dritte Zeitpunkt derart gewählt, daß in einem Zugriffszyklus der Speicherkondensator der auszuwählenden Speicherzelle jeweils um den gleichen Betrag aufgeladen und entladen wird.

Der ferroelektrische Speicher wird in einem sogenannten "Pulsed Plate Concept" betrieben, bei dem die Plattenleitung gepulste Signale aufweist. Zur Vermeidung eines Informationsverlusts in nicht ausgewählten Speicherzellen wird der Zeitablauf eines Zugriffszyklus in geeigneter Weise gesteuert. Werden dazu der erste Zeitpunkt, der zweite Zeitpunkt und der dritte Zeitpunkt derart gewählt, daß der ausgewählte Speicherkondensator jeweils um den gleichen Betrag aufgeladen und entladen wird, so wird dieser Effekt auch bei nicht ausgewählten Speicherkondensatoren erreicht, die sich in Folge von Source-Drain-Leckströmen auf- bzw. entladen. Wird ein Zugriffszyklus zeitlich nach dem erfindungsgemäßen Verfahren gesteuert, so geht ein Gleichspannungsanteil der Differenzspannung zwischen der Plattenleitung und der betreffenden Spaltenleitung gegen Null. Die Differenzspannung enthält nur noch einen reinen Wechselspannungsanteil, d.h., ein angeschlossener Speicherkondensator wird während eines Zugriffszyklus jeweils um den gleichen Betrag aufgeladen und wieder entladen.

Ein vorhandener Gleichspannungsanteil läßt sich mathematisch durch Integration der Differenzspannung zwischen der Plattenleitung und der entsprechenden Spaltenleitung über der Zeit errechnen. Weist dieses Integral am Ende des Zugriffszyklus einen Wert auf, der gegen Null geht, so ist kein Gleichspannungsanteil der Differenzspannung vorhanden.

Als Zeitspanne zwischen dem ersten Zeitpunkt und dem dritten Zeitpunkt wird beispielsweise die technisch kürzest mögliche Zeitspanne gewählt. Das heißt, die Steuerung des zeitlichen Ablaufs bei einem Speicherzugriff wird nur durch entsprechende Wahl des ersten Zeitpunkts eingestellt.

Weitere vorteilhafte Aus- und Weiterbildungen sind Gegenstand abhängiger Ansprüche.

Die Erfindung wird im folgenden anhand der in der Zeichnung dargestellten Figuren, die Ausführungsbeispiele darstellen, näher erläutert. Es zeigen:
- Figur 1: eine schematische Darstellung eines integrierten ferroelektrischen Speichers,
- Figur 2: einen zeitlichen Ablauf eines Lesezyklus des integrierten Speichers,
- Figur 3: einen zeitlichen Ablauf eines Lesezyklus nach dem erfindungsgemäßen Verfahren.

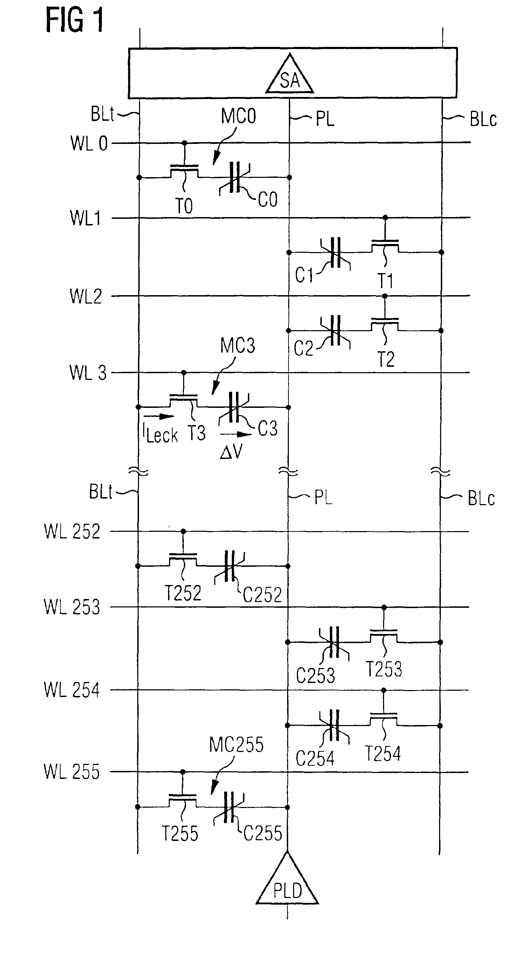

Figur 1 ist eine schematische Darstellung einer Ausführungsform eines integrierten ferroelektrischen Speichers zu entnehmen. Dieser weist sogenannte 1-Transistor/1-Kondensator-Speicherzellen MC auf, die in Kreuzungspunkten jeweils eines Bitleitungspaares BLt, BLc mit Wortleitungen WL0 bis WL255 angeordnet sind. Zwischen den beiden Bitleitungen BLt bzw. BLc verläuft eine Plattenleitung PL. Die Bitleitungen BLt, BLc bzw. Spaltenleitungen sind an einen Leseverstärker SA angeschlossen. Die Plattenleitung PL ist mit einer Treiberschaltung PLD verbunden, durch die die Plattenleitung PL an einem vorgegebenen Potential anliegt. Die Speicherzellen MC weisen jeweils einen der Auswahltransistoren T0 bis T255 und einen der Speicherkondensatoren C0 bis C255 auf. Bei den Speicherkondensatoren handelt es sich um Speicherkondensatoren mit ferroelektrischem Speichereffekt. Die Plattenleitung PL ist beispielsweise über die Reihenschaltung des Auswahltransistors T0 und des Speicherkondensators C0 der Speicherzelle MC0 mit der Spaltenleitung BLt verbunden. Die Steueranschlüsse der Auswahltransistoren T0 bis T255 der Speicherzellen MC sind mit jeweils einer der Zeilenleitungen bzw. Wortleitungen WL0 bis WL255 verbunden.

Im folgenden wird ein beispielhafter Lesezugriff des in Figur 1 gezeigten Speichers näher erläutert. Das erfindungsgemäße Verfahren ist sinngemäß ebenfalls auf einen Schreibzyklus des integrierten Speichers anwendbar.

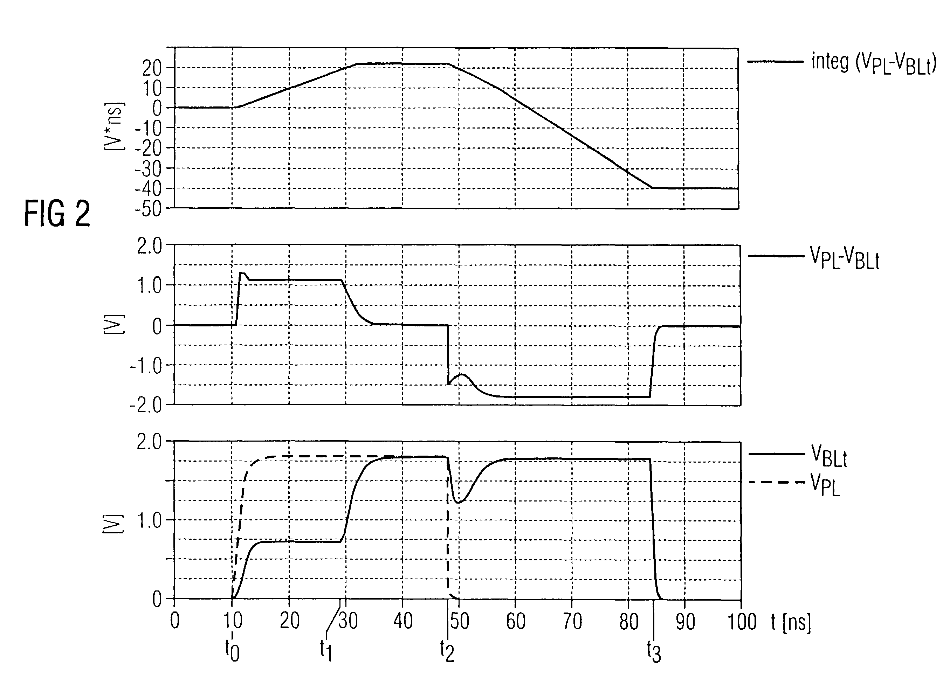

Während eines Lesezugriffs des Speichers treten auf der Bitleitung BLt und der Plattenleitung PL die in Figur 2 gezeigten Potentialverläufe VBLt und VPL auf. Es wird angenommen, daß die Speicherzelle MC0 aktiviert wird. Vor dem Lesezugriff weisen die Spaltenleitung BLt und die Plattenleitung PL, die an der auszuwählenden Speicherzelle MC0 angeschlossen sind, ein Ausgangspotential auf. Das Ausgangspotential ist in diesem Beispiel ein Bezugspotential des integrierten Speichers. Der Auswahltransistor T0 wird zu Beginn des Lesezugriffs durch ein positives Potential, das an der Wortleitung WL0 anliegt, leitend geschaltet. Die Zeilenleitung WL0 wird dazu aktiviert. Gleichzeitig wird an der Plattenleitung PL ein positives Potential VPL angelegt, das unterschiedlich zum Potential VBLt der Spaltenleitung BLt ist. Dieser Zeitpunkt ist als Zeitpunkt t0 gekennzeichnet.

Auf der Bitleitung BLt stellt sich nun eine Lesespannung entsprechend der in der Speicherzelle MC0 gespeicherten Information ein. Dieses Lesesignal wird mit einer Referenzspannung verglichen und in dem angeschlossenen Leseverstärker SA bewertet und verstärkt. Dieser Zeitpunkt ist als Zeitpunkt t1 gekennzeichnet. Nach einer gewissen Zeitspanne, die zum Zurückschreiben der Information in die Speicherzelle MC0 benötigt wird, wird die Plattenleitung PL wieder an das Ausgangspotential angelegt. Dieser Zeitpunkt ist als Zeitpunkt t2 gekennzeichnet. Nach einer weiteren Wartezeit wird zum Zeitpunkt t3 auch die Bitleitung BLt an das Ausgangspotential angelegt. Zum Ende des Lesezyklus wird die Wortleitung WL0 deaktiviert und damit der Auswahltransistor T0 wieder geschlossen. Diese Betriebsart eines ferroelektrischen Speichers wird auch als "Pulsed Plate Concept" bezeichnet. Die Figur 2 zeigt dabei typische Signalverläufe für einen derartigen Zugriff.

An die Bitleitung BLt und die Plattenleitung PL sind weitere Speicherzellen MC angeschlossen, die im oben beschriebenen Zugriffszyklus nicht aktiviert werden. Das heißt, deren Wortleitungen WL werden nicht aktiviert, wodurch die zugehörigen Auswahltransistoren geschlossen sind. Über der jeweiligen Source-Drain-Strecke dieser Auswahltransistoren liegt während des Zugriffszyklus die in Figur 1 gezeigte Differenzspannung VPL - VBLt an. Diese Source-Drain-Spannung kann einen Leckstrom verursachen, der den zugehörigen Speicherkondensator auf- bzw. entlädt.

Durch Integration dieser Differenzspannung über der Zeit erkennt man, daß diese Differenzspannung im hier gezeigten Fall einen Gleichspannungsanteil enthält (in Figur 2 dargestellt durch das Integral der Differenzspannung integ(VPL-VBLt) ungleich Null am Ende des Zugriffszyklus). Dieser Gleichspannungsanteil bewirkt nun, daß bei jedem Zugriffszyklus die nicht ausgewählten Speicherkondensatoren durch Leckströme um eine gewisse Ladungsmenge aufgeladen werden. Diese Ladungsmenge ΔQ ist proportional dem Produkt aus Leckstrom ILeck und dem Integral der Differenz zwischen den Potentialen der Plattenleitung PL und der Bitleitung BLt über der Zeit.

Dadurch erhöht sich nach jedem Zugriffszyklus die Spannung, die an den Anschlüssen des jeweiligen Speicherkondensators anliegt, um einen Betrag ΔV, der ebenfalls proportional dem Produkt aus Leckstrom ILeck und dem Integral der Differenzspannung über der Zeit ist (ΔV ∼ ILeck · integ(VPL-VBLt)). Diese Potentialzunahme ΔV, die beispielhaft am Speicherkondensator C3 dargestellt ist, schwächt oder zerstört aufgrund des Leckstroms ILeck des Auswahltransistors T3 mit der Zeit, beispielsweise über mehrere Zugriffszyklen, die in der Speicherzelle MC3 gespeicherte Information.

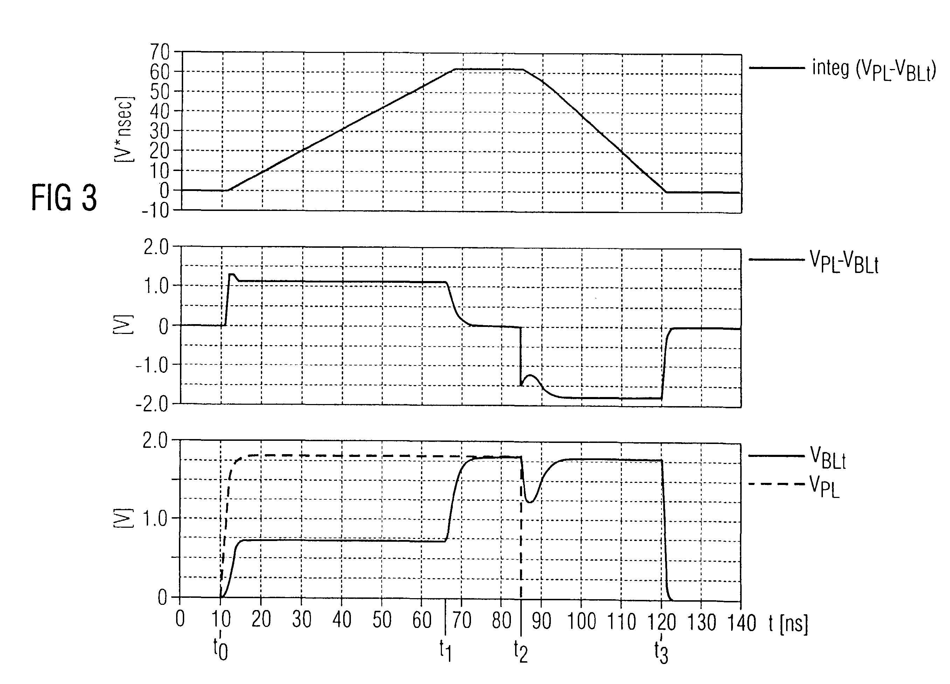

In Figur 3 ist ein beispielhafter zeitlicher Ablauf eines Lesezyklus gezeigt, der nach dem erfindungsgemäßen Verfahren durchgeführt wird. Wie der Figur 3 zu entnehmen, wird der zeitliche Ablauf derart modifiziert, daß nun das Integral der Differenz zwischen den Potentialen der Plattenleitung PL und der Bitleitung BLt über der Zeit gegen Null geht. Das heißt, der Gleichspannungsanteil der Differenzspannung VPL - VBLt geht gegen Null. Diese Differenzspannung enthält also nur noch einen reinen Wechselspannungsanteil. Das bedeutet, einer der inaktiven Speicherkondensatoren wird während eines Zugriffszyklus durch einen vorhandenen Source-Drain-Leckstrom zwar um einen gewissen Betrag aufgeladen, im gleichen Zyklus jedoch um den gleichen Betrag wieder entladen.

In Figur 3 wurde der Betrieb des Speichers so gewählt, daß die Zeitspanne zwischen dem Zeitpunkt t1 und dem Zeitpunkt t3 die technisch kürzest mögliche Zeitspanne darstellt, um die Signale entsprechend zu verarbeiten. Im Vergleich zu dem Verlauf nach Figur 2 wurde der Zeitpunkt t1 so gewählt, daß die Zeitspanne zwischen dem Zeitpunkt t0 und t1 dementsprechend verlängert wird.

Die in den Figuren 2 und 3 gezeigten Absolutwerte der Zeit und der jeweiligen Spannung sind beispielhafte Werte. Da die Spannungswerte und Ladungswerte an den jeweiligen Speicherzellen stark design- und technologieabhängig sind, können diese in einem vergleichsweise großen Bereich schwanken.

## Patentansprüche

1. Verfahren zum Betrieb eines integrierten Speichers
- mit einem Speicherzellenfeld, das Spaltenleitungen (BLt, BLc) und Zeilenleitungen (WL) aufweist,
- mit Speicherzellen (MC0; MC255), die jeweils einen Auswahltransistor (T0, T255) und einen Speicherkondensator (C0, C255) mit ferroelektrischem Speichereffekt aufweisen,
- mit einer Plattenleitung (PL), die über eine Reihenschaltung des Auswahltransistors (T0) und des Speicherkondensators (C0) jeweiliger Speicherzellen (MC0) mit einer der Spaltenleitungen (BLt) verbunden ist,
- bei dem Steueranschlüsse der Auswahltransistoren (T0, T255) der Speicherzellen mit jeweils einer der Zeilenleitungen (WL0, WL255) verbunden sind,
- bei dem ein Zugriff auf eine der Speicherzellen (MC0) in einem Zugriffszyklus erfolgt,
mit den Merkmalen:
- vor einem Zugriff weisen die Spaltenleitung (BLt) und die Plattenleitung (PL), die an einer auszuwählenden Speicherzelle (MC0) angeschlossen sind, ein Ausgangspotential auf,
- während eines Zugriffs wird die Zeilenleitung (WL0) aktiviert, die an der auszuwählenden Speicherzelle (MC0) angeschlossen ist, so daß deren Auswahltransistor (T0) leitend geschaltet ist, und es wird an die Plattenleitung (PL) ein Potential (VPL) angelegt, das unterschiedlich zum Potential (VBLt) der Spaltenleitung (BLt) ist,
- das an der Spaltenleitung (BLt) anliegende Potential (VBLt) wird zu einem ersten Zeitpunkt (t1) bewertet und verstärkt,
- danach wird das Ausgangspotential zu einem zweiten Zeitpunkt (t2) an die Plattenleitung (PL) angelegt,
- danach wird das Ausgangspotential zu einem dritten Zeitpunkt (t3) an die Spaltenleitung (BLt) angelegt,
- es sind dabei der erste Zeitpunkt (t1), der zweite Zeitpunkt (t2) und der dritte Zeitpunkt (t3) derart gewählt, daß in einem Zugriffszyklus der Speicherkondensator (C0) der auszuwählenden Speicherzelle (MC0) jeweils um den gleichen Betrag aufgeladen und entladen wird.

2. Verfahren nach Anspruch 1,
**dadurch gekennzeichnet, daß**
das Ausgangspotential ein Bezugspotential des integrierten Speichers ist.

3. Verfahren nach einem der Ansprüche 1 bis 2,
**dadurch gekennzeichnet, daß**
der Zugriff auf eine der Speicherzellen (MC0) ein Lesezugriff zum Auslesen eines Datensignals der Speicherzelle (MC0) ist.
